# EUROPÄISCHE PATENTSCHRIFT

(11) **EP 0 325 590 B1**
(45) Veröffentlichungstag und Bekanntmachung des Hinweises auf die Patenterteilung: **17.02.1993**
(21) Anmeldenummer: 87905744.6
(22) Anmeldetag: 26.08.1987
(51) Int. Cl.: H03H 21/00

(54) **SCHALTUNGSANORDNUNG ZUR UMWANDLUNG EINES DURCH EINE STÖRFUNKTION GESTÖRTES MESSIGNALS IN EIN UNGESTÖRTES SIGNAL**
CIRCUITRY FOR CONVERTING MEASUREMENT SIGNALS DISTURBED BY A DISTURBANCE FUNCTION INTO UNDISTURBED SIGNALS
CIRCUIT DE CONVERSION DE SIGNAUX DE MESURE PERTURBES PAR UNE FONCTION DE PERTURBATION EN SIGNAUX NON-PERTURBES

(30) Priorität: 08.10.1986 DE 3634239
(43) Veröffentlichungstag der Anmeldung: 02.08.1989
(73) Patentinhaber: ROBERT BOSCH GMBH, 70442 Stuttgart (DE)
(72) Erfinder: VAN ZANTEN, Anton, D-7257 Ditzingen 4 (DE); KOST, Friedrich, D-7000 Stuttgart 50 (DE)
(74) Vertreter: Kammer, Arno, Dipl.-Ing.
(86) Internationale Anmeldenummer: EP8700484
(87) Internationale Veröffentlichungsnummer: WO8802954

(56) Entgegenhaltungen:
- EP-A- 0 086 943
- 1980 IEEE International Symposium on Circuits and Systems Proceedings, Houston, Texas, 28.-30. April 1980, vol. 3, IEEE, (US), J.M. McCool et al.: "Principles and applications of adaptive filters; a tutorial review", pages 1143-1157; see figure 22; page 1154, left column, lines 1-17
- IEEE Transactions on Power Apparatus and Systems, vol. PAS-104, No: 12, December 1985, IEEE, (New York, US), H.J. Trussel et al.: "Cancellation of harmonic noise in distribution line communications", pages 3338-3344, see figures 7,8; pages 3341-3342: "Implementation"

## Beschreibung

Die Erfindung betrifft eine Schaltungsanordnung mit den Merkmalen des Oberbegriffs des Anspruchs 1.

Problembeschreibung und Stand der Technik.

Mißt man z.B. die Geschwindigkeit eines Fahrzeugrads, z.B. zum Zwecke der Bremsdruckregelung, so stellt man fest, daß dem Meßsignal häufig ein Störsignal einer oder mehrerer bestimmter Frequenzen überlagert ist, welches die ausgewerteten Signale (z.B. das Radgeschwindigkeitssignal selbst oder seine Ableitungen) verfälschen kann.

Es ist ganz allgemein bekannt, daß man es vermag, durch Filterung Störsignale zu beseitigen. Die Frequenzen der Störungen sind häufig jedoch nicht bekannt und auch in Abhängigkeit von bestimmten Einflüssen variabel. Für eine solche Filterung eignen sich daher sogenannte adaptive digitale Filter, die jedoch so eingestellt werden müssen, daß jeweils nur das Störsignal ausgefiltert wird. Adaptive Filter sind z.B. aus EP-A3 0 086 943 bekannt.

### Vorteile der Erfindung

Die Erfindung gemäß den Merkmalen des Patentanspruchs 1 hat eine Schaltungsanordnung zum Inhalt, die in Phasen, in denen das Störsignal getrennt darstellbar ist, die Filterparameter des Störsignals bestimmt, und vergleicht ob die neu festgestellten Parameter eine bessere Filterung als die vorher eingestellten Parameter bewirken und wenn dies der Fall ist, diese Parameter auf das eigentliche Filter (das erste adaptive digitale Filter) übertragen. Vorzugsweise werden hierbei zwei sogenannte adaptive ladder-Filter benutzt.

Wenn die ladder Filterparameter an ein Störsignal angepaßt sind, dann steht am Ausgang des Filters das Nutzsignal an (Eingangssignal minus Störsignal). Damit sichergestellt ist, daß das Eingangssignal während der Parameterbestimmung kein Nutzsignal enthält, wird das Störsignal nur zu bestimmten Zeiten aus dem Eingangssignal gewonnen; zum Beispiel zeigt bei einem Antiblockierregler (ABS) nach dem Druckabbau im Radbremszylinder die Radgeschwindigkeit häufig Schwingungen, die auch als Achsschwingungen bezeichnet werden. Um diese AchsSchwingungen aus dem Radsignal heraus zu filtern, wird das zweite adaptive ladder Filter dann auf "Adaption" geschaltet, wenn nach dem Druckabbau das Rad wieder ins stabile Gebiet der Reifenschlupfkurve eingelaufen ist. Die Adaption wird abgebrochen, spätestens wenn ein Druckaufbaupuls erfolgt. Nach dieser Adaption werden dem ersten adaptiven Filter, das das Radsignal V_{R} fortwährend filtert, die neuen Filterparameter übergeben.

### Figurenbeschreibung

Anhand der Zeichnung wird ein Ausführungsbeispiel der Erfindung beschrieben. Es zeigen:
Figur 1 - ein Blockschaltbild eines Ausführungsbeispiels,
Figur 2 - ein Diagramm zur Erläuterung.

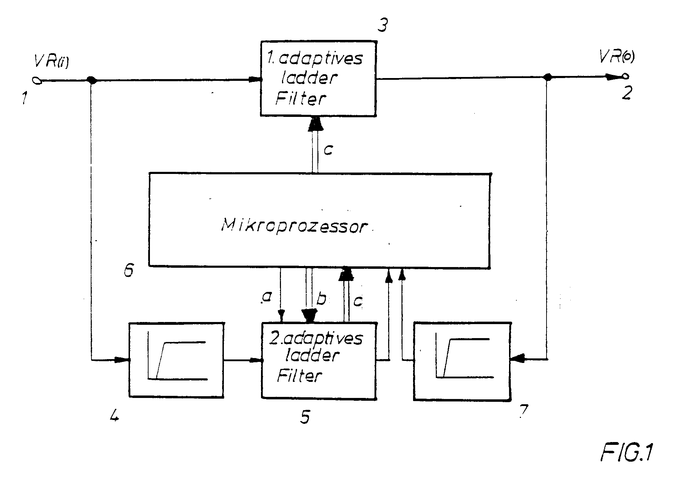

Durch Figur 1 ist die Struktur für die adaptive Filterung des gestörten Signals V_{R} gegeben. V_{R(i)} ist die ungefilterte und V_{R(o)} die gefilterte Radgeschwindigkeit.

In den Signalweg zwischen die Klemmen 1 und 2 ist ein erstes adaptives ladder Filter 3 eingeschaltet. Das Radgeschwindigkeitssignal V_{R(i)} wird aber auch einem Hochpaßfilter 4 zugeführt, dem ein zweites adaptives ladder Filter 5 nachgeschaltet ist. Zur Steuerung der Filter 3 und 5 ist ein Mikroprozessor 6 vorgesehen. Außerdem ist noch ein weiteres Hochpaßfilter 7 vorgesehen dem das entstörte Signal (V_{R(o)} zugeführt wird. Die Ausgänge der Filter 5 und 7 werden auf einen Vergleicher im Mikroprozessor 6 geführt.

Die adaptiven Filter 3 und 5 werden in ihrer Funktion von einem Mikroprozessor gesteuert. Der Mikroprozessor entscheidet, wann die Adaption im adaptiven ladder Filter 5 anfangen soll und wann sie wieder aufhören soll. Weiter entscheidet der Mikroprozessor, ob die neuen Parameter vom adaptiven ladder Filter 3 übernommen werden sollten. Für die letzte genannte Entscheidung wird der Ausgang des adaptiven ladder Filters 3 durch das zweite Hochpaßfilter 7 gefiltert und der Ausgang dieses Hochpaßfilters 7 wird mit dem Ausgang des adaptiven ladder Filters 5 im Vergleicher im Mikroprozessor 6 verglichen.

Die Radgeschwindigkeit V_{R(i)} wird ständig durch das erste adaptive ladder Filter 3 gefiltert. Am Ausgang dieses ladder Filters steht die gefilterte Radgeschwindigkeit V_{R(o)} an. Weiter werden die Radgeschwindigkeiten V_{R(i)} und V_{R(o)} durch das erste (4) bzw. das zweite Hochpaßfilter (7) gefiltert. Die beiden Hochpaßfilter sind identisch. Diese Hochpaßfilter filtern den Mittelwert und den Trend aus dem Radgeschwindigkeitssignal heraus.

Der Mikroprozessor 6 entscheidet, wann die Adaption starten soll. Dazu bekommt das adaptive ladder Filter 5 ein entsprechendes Signal über die Leitung a und es werden, je nach Bedarf, die Parameter dieses Filters, die sogenannten Reflektionskoeffizienten und die Kovarianz, über die Leitung b initialisiert, d.h. die Anfangswerte der Parameter werden vorbesetzt, z.B. den Werten des Filters 3 angeglichen.

Der Mikroprozessor entscheidet weiter, wann die Parameterschätzung im adaptiven ladder Filter 5 abgebrochen werden sollte. Ist dies der Fall, so schickt der Mikroprozessor ein entsprechendes Signal über die Leitung a.

Sollen die vom adaptiven ladder Filter 5 geschätzten Parameter in das adaptive ladder Filter 3 übernommen werden, so liest der Mikroprozessor 6 die Parameter über Leitung c aus dem adaptiven Filter 5 aus und schreibt sie über Leitung d in das adaptive ladder Filter 3 ein.

Der Mikroprozessor entscheidet über diese Übernahme der Parameter aufgrund des Vergleichs der Ausgänge des adaptiven ladder Filter 5 und des Zweiten Hochpaßfilters 7. Diese Entscheidung kann auf verschiedenen Grundlagen basierend gefällt werden. Eine mögliche Grundlage wären die Kovarianzen (= Quadrat der Standardabweichung vom Störsignal) der beiden Ausgangssignale. Die Entscheidung wäre dann wie folgt: Wenn die Kovarianz des Ausgangs des Zweiten Hochpaßfilters 7 größer ist als die des adaptiven ladder Filters 5 ist, dann ist das (Stör)signal am Ausgang von 7 größer als das (Stör)signal am Ausgang von 5 und das adaptive ladder Filter 3 nicht mehr optimal abgestimmt und die Parameter des adaptiven ladder Filters 5 werden vom ersten adaptiven ladder Filter 3 übernommen.

Die adaptiven ladder Filter, insbesondere die normalisierte Form solcher adaptiven ladder Filter, können sehr gut als VLSI-Bausteine ausgelegt werden, da ihre Struktur rekursiv ist. Es sei hier auf die Literatur verwiesen. Die Hochpaßfilter können auch als VLSI-Bausteine aufgebaut oder auch im Mikroprozessor implementiert werden. Die Algorithmen der Hochpaßfilter sind Stand der Technik. Die Algorithmen sowohl der nicht normalisierten als auch der normalisierten adaptiven ladder Filter sind im Anhang aufgeschrieben.

In Fig. 2a ist der Verlauf der Fahrzeuggeschwindigkeit V_{F} und der Radgeschwindigkeit V_{R(i)} eines gebremsten Fahrzeugs mit Antiblockierregelung dargestellt. Im Bereich t₁ bis t₂ tritt hier eine Störung auf, die als Achsschwingung bekannt ist; diese Störung kann unnötigerweise bereits einen neuen Druckabbau auslösen (z.B. über ein Verzögerungssignal).

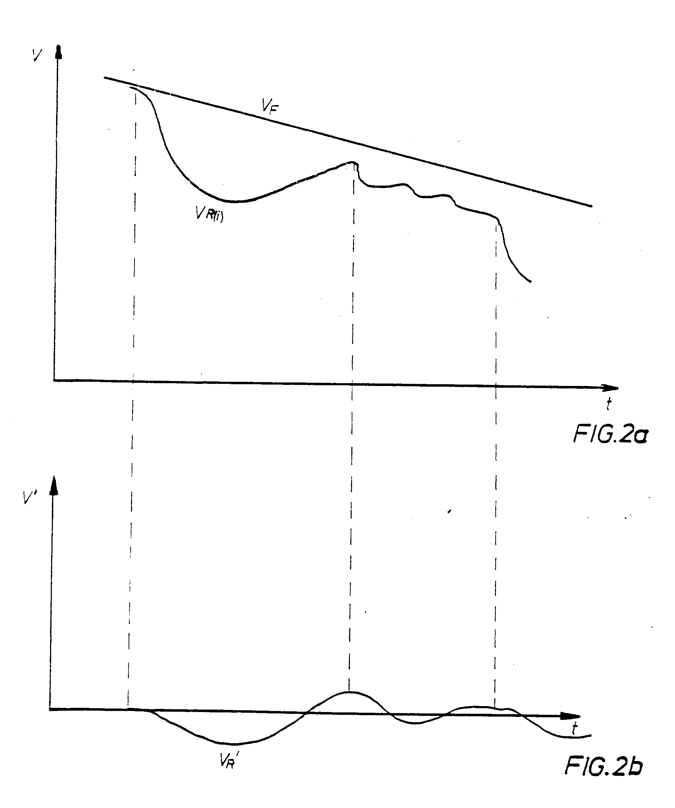

Durch das Hochpaßfilter 4 der Fig. 1 wird hieraus der Verlauf des Geschwindigkeitssignals V_{R}' der Fig. 2b gewonnen. Im Zeitraum t₁ bis t₂ tritt hier praktisch nur die Störung auf (keine Radgeschwindigkeitsänderung). Im ladder-Filter 5, das vom Mikroprozessor 6 wirksam gemacht wird, werden in dieser Zeit (Umschaltung auf Adaption) die Filterparameter zur Ausfilterung dieser Störung bestimmt. In nachfolgenden Regelzyklen, während den t₂ - t₁ entsprechenden Zeitabschnitten, werden die Ausgänge der Filter 5 und 7 miteinander im Mikroprozessor 6 verglichen und festgestellt, ob die Filterkombination 3 und 7 oder die Filterkombination 4 und 5 das Störsignal besser ausfiltert. Ist die Filterung der Filterkombination 4 und 5 besser, so werden die vom ladder Filter 5 festgestellten Parameter für die Störfilterung auf das ladder Filter 3 übertragen.

Die Feststellung der Parameter im ladder Filter 5 erfolgt also nicht kontinuierlich, sondern nur von Zeit zu Zeit.

Die Festlegung des Zeitraums t₁ bis t₂ der Parameterbestimmung im ladder Filter erfolgt mit Hilfe der Signale des Antiblockierreglers. Dieser Zeitraum kann z.B. der nach einem Druckabbau folgenden Druckkonstanthaltephase, nach dem eine Beschleunigungsschwelle unterschritten ist, entsprechen.

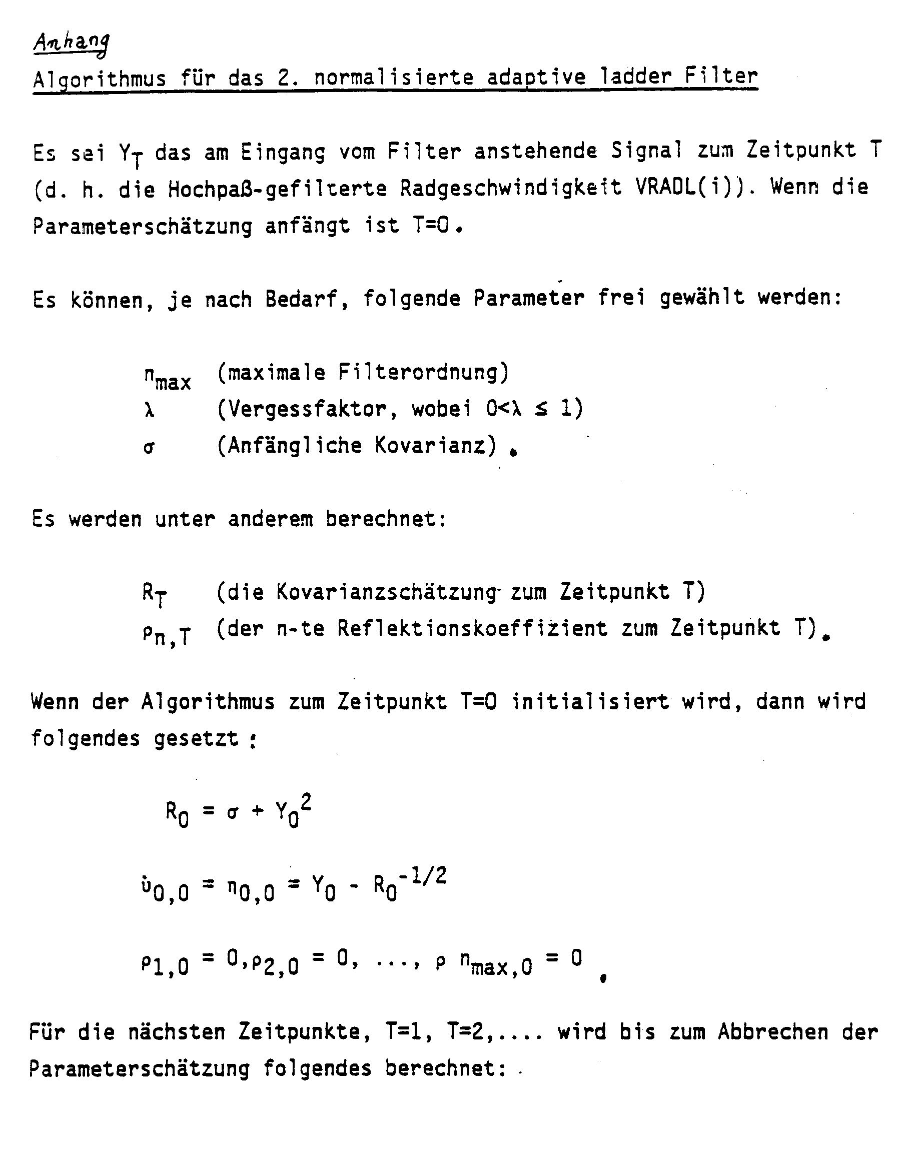

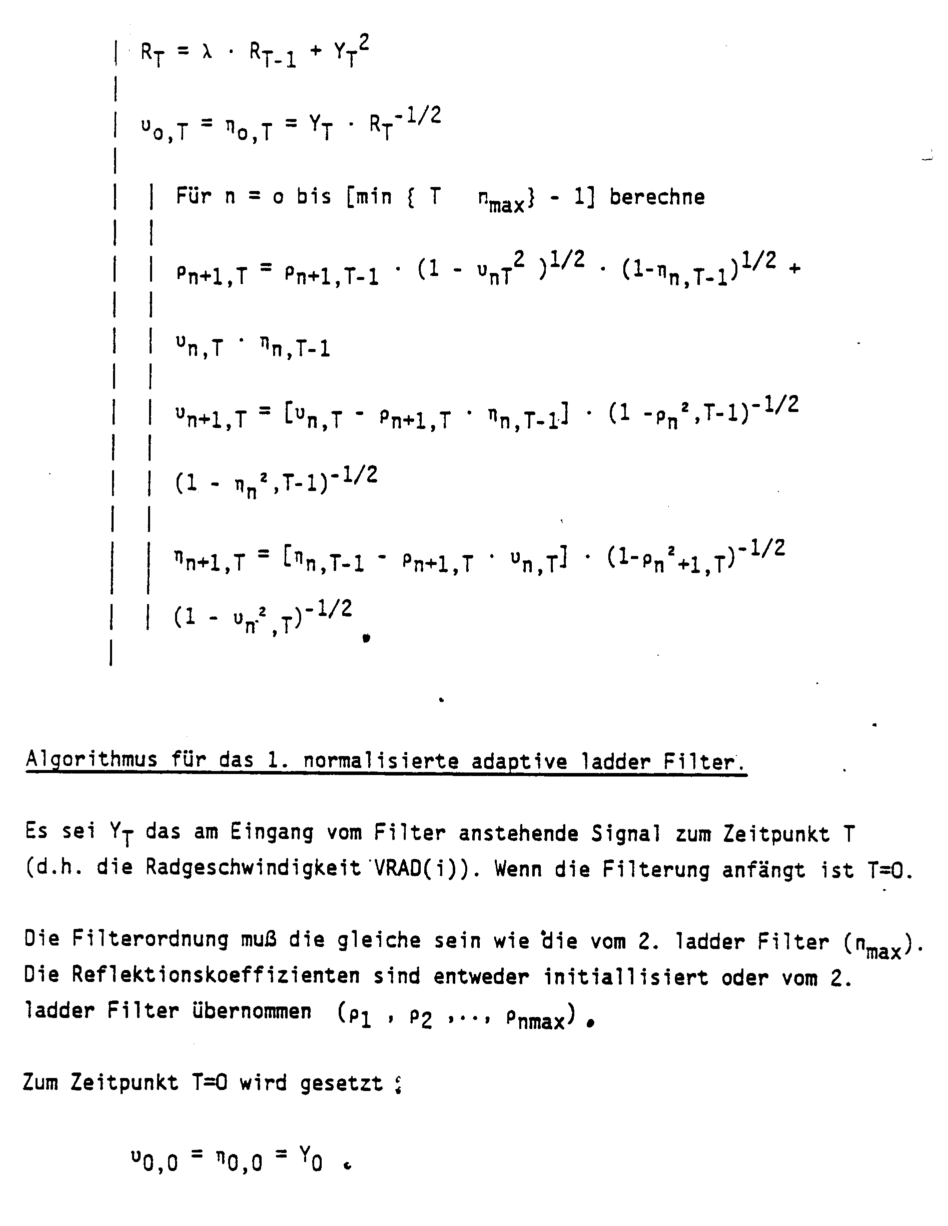

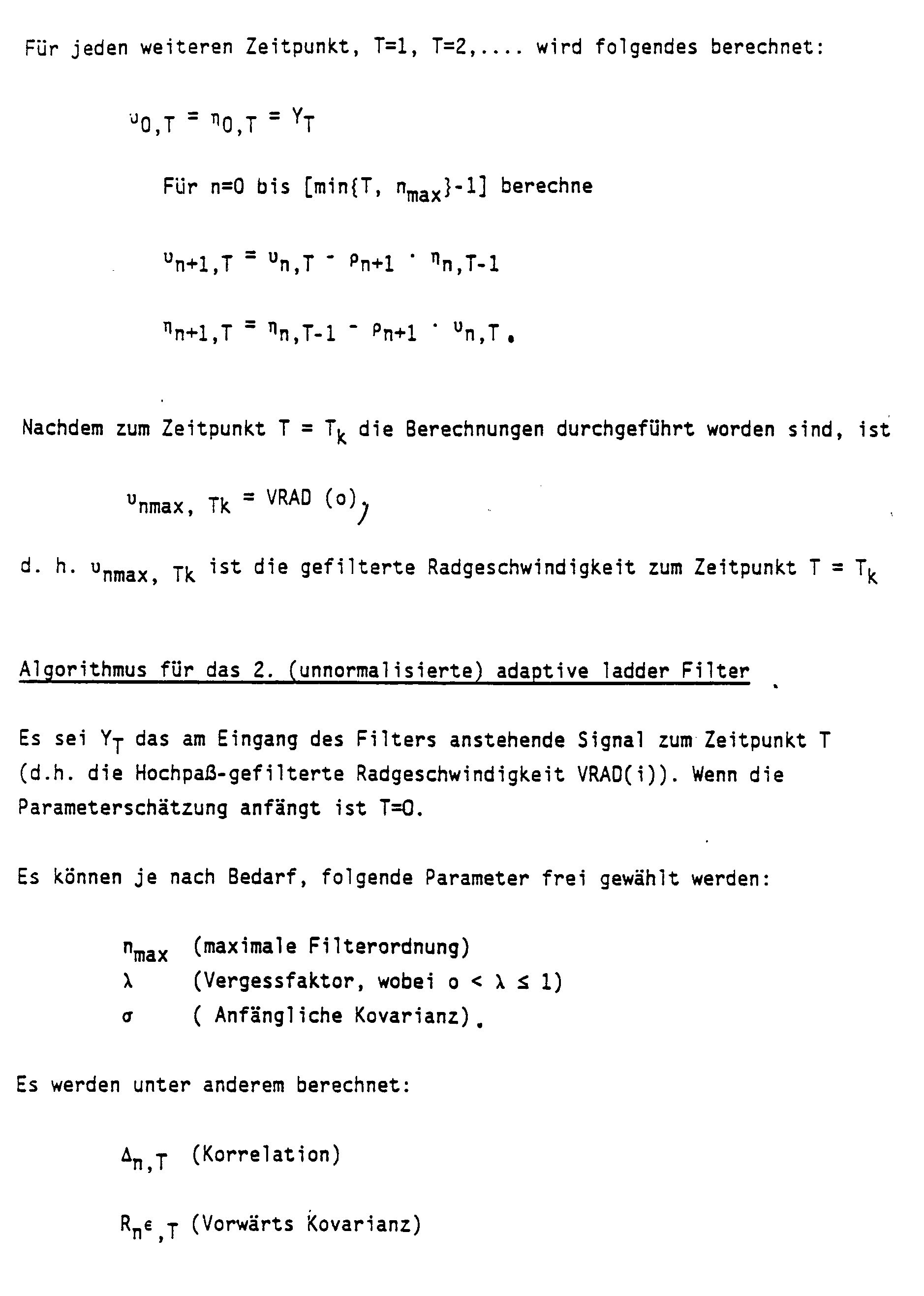

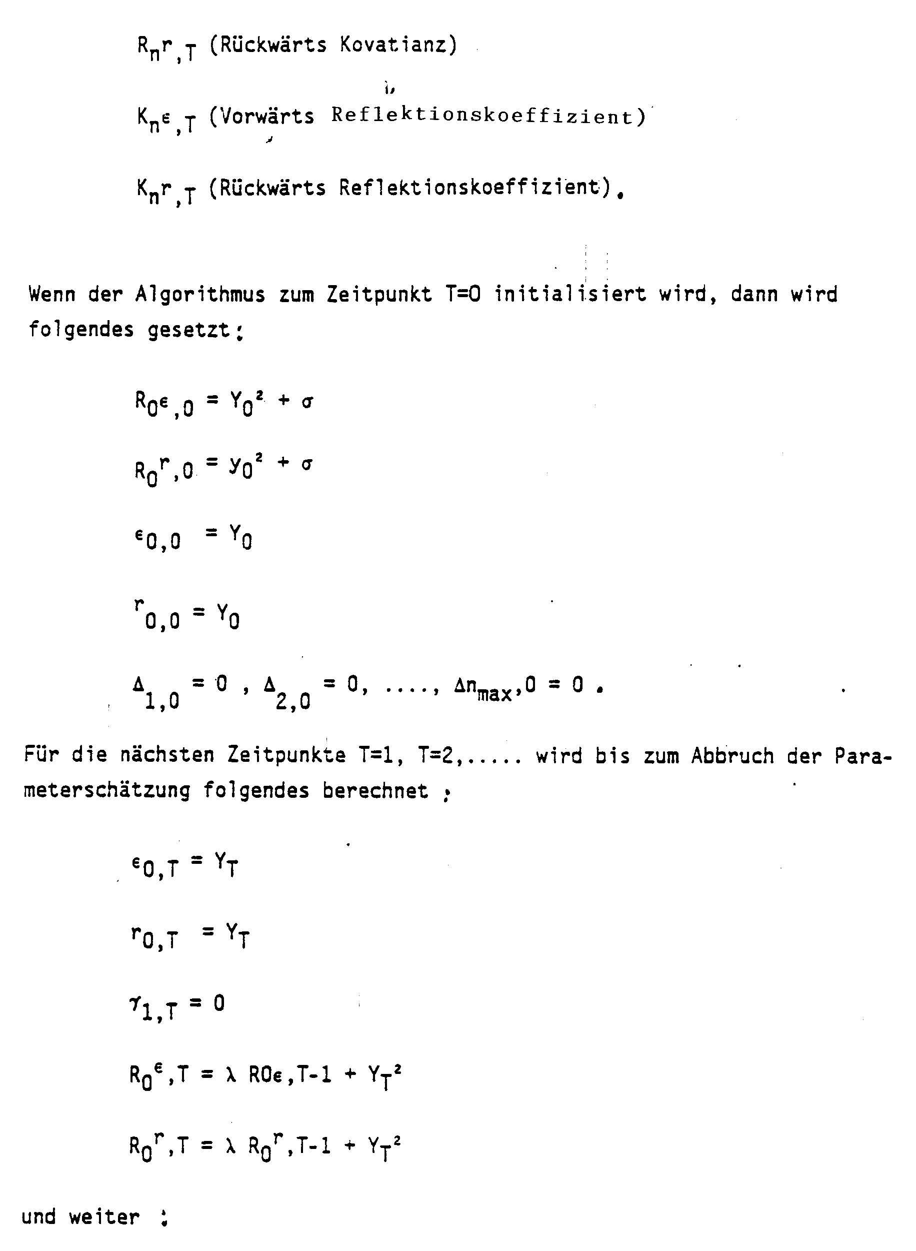

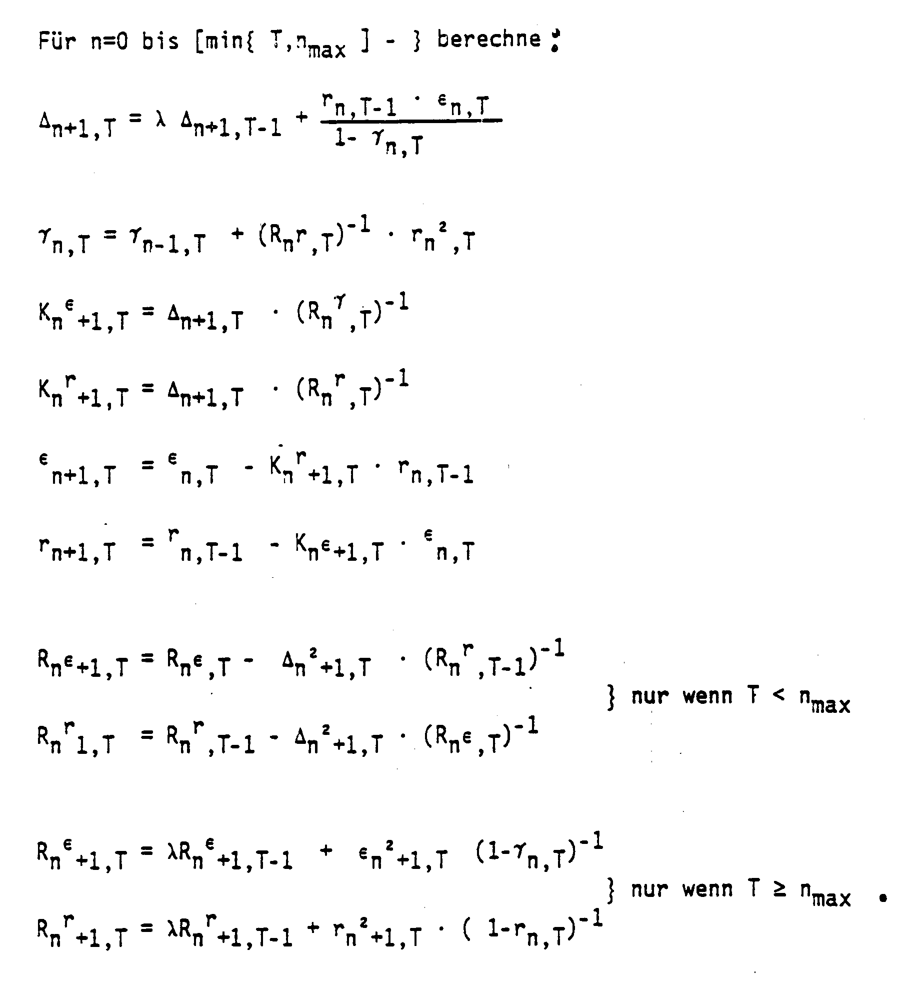

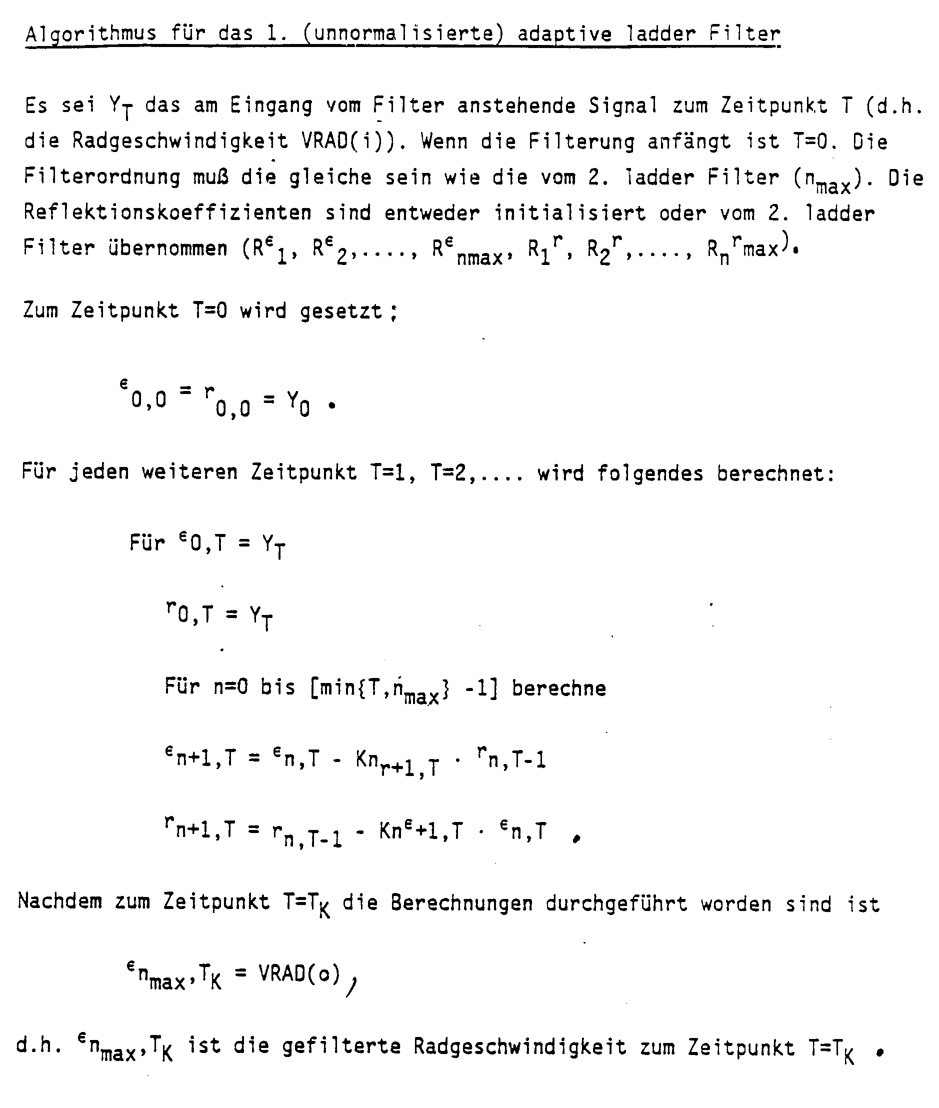

## Patentansprüche

1. Schaltungsanordnung zur Umwandlung eines zumindest zeitweise durch eine Störfunktion gestörten Meßsignals V_{R(i)} in ein ungestörtes Signal V_{R(o)} unter Verwendung eines Filters, dessen Filterparameter verändert werden, dadurch gekennzeichnet, daß das Filter ein erstes digitales, adaptives Filter (3) ist, und daß dessen Parameterveränderung mittels einer Steuerschaltung (6), einem ersten Hochpaßfilter(4) mit nachgeschaltetem zweiten digitalen, adaptiven Filter (5), welcher Reihenschaltung das gestörte Meßsignal V_{R(i)} zugeführt wird, bewirkt wird, wobei die Steuerschaltung einmal einen Zeitraum bestimmt, während dem im wesentlichen nur die Störfunktion zum zweiten digitalen, adaptiven Filter (5) gelangt und in dem das zweite digitale adaptive Filter auf Adaption zur Bestimmung der für die Unterdrückung der Störfunktion notwendige Filterparameter geschaltet wird und zum anderen die Übernahme der dabei gewonnenen Filterparameter auf das erste adaptive Filter (3) bestimmt.

2. Schaltungsanordnung nach Anspruch 1, dadurch gekennzeichnet, daß ein zweites Hochpaßfilter (7), dem das ungestörte Signal V_{R(o)} zugeführt wird und ein Vergleicher (in 6) vorgesehen sind, dem die Ausgänge des zweiten digitalen, adaptiven Filters (5) und des zweiten Hochpaßfilters (7) zugeführt werden, und der die Übergabe an das erste adaptive Filter (3) veranlaßt, wenn der Vergleicher (in 6) eine bessere Abstimmung des zweiten digitalen, adaptiven Filters (5) feststellt.

3. Schaltungsanordnung nach Anspruch 1 oder 2, dadurch gekennzeichnet, daß die adaptiven Filter (3, 5) adaptive ladder Filter sind.

4. Schaltungsanordnung nach einem der Ansprüche 1 bis 3, dadurch gekennzeichnet, daß der Zeitraum für die Umschaltung des zweiten adaptiven Filters (5) auf Adaption bei einem Antiblockierregler (ABS) durch das Unterschreiten einer Radbeschleunigungsschwelle nach einem Druckabbau bestimmt ist.

## Claims

1. Circuit arrangement for converting a measurement signal V_{R(i)} at least intermittently disturbed by a disturbance function into an undisturbed signal V_{R(0)} by the use of a filter whose filter parameters are varied, characterised in that the filter is a first digital, adaptive filter (3), and in that the parameter variation thereof is effected by means of a control circuit (6), a first high-pass filter (4) having a second digital, adaptive filter (5) connected downstream, to which series circuit the disturbed measurement signal V_{R(i)} is fed, the control circuit firstly determining a period during which essentially only the disturbance function reaches the second digital, adaptive filter (5) and in which the second digital adaptive filter is switched to adaptation in order to determine the filter parameters required for the suppression of the disturbance function and, secondly, determines the acceptance [sic] of the filter parameters thereby obtained to the first adaptive filter (3).

2. Circuit arrangement according to Clad 1, characterised in that a second high-pass filter (7), to which the undisturbed signal V_{R(0)} is fed, and a comparator (in 6) are provided to which the outputs of the second digital, adaptive filter (5) and of the second high-pass filter (7) are fed, and which causes the transfer to the first adaptive filter (3) when the comparator (in 6) determines a better tuning of the second digital, adaptive filter (5).

3. Circuit arrangement according to Claim 1 or 2, characterised in that the adaptive filters (3, 5) are adaptive ladder filters.

4. Circuit arrangement according to one of Claims 1 to 3, characterised in that the period for the changeover of the second adaptive filter (5) to adaptation in the case of an antilock controller (ABS) is determined by the undershooting of a wheel acceleration threshold after a pressure decrease.

## Revendications

1. Circuit de conversion d'un signal de mesure V_{R(i)} perturbé par une fonction de perturbation en un signal non perturbé V_{R(o)} constitué en utilisant un filtre, dont les paramètres de filtrage sont modifiés, circuit caractérisé en ce que le filtre est un premier filtre numérique adaptatif (3) et en ce que la modification de ses paramètres est générée au moyen d'un circuit de commande (6), d'un premier filtre passe-haut (4) avec un deuxième filtre adaptatif numérique monté en aval (5), lequel circuit en série reçoit le signal de mesure V_{R(i)} perturbé, le circuit de commande déterminant une fois un instant, tandis qu'essentiellement seule la fonction de perturbation arrive au deuxième filtre numérique adaptatif (5) et dans lequel le deuxième filtre adaptatif numérique est branché sur l'adaptation pour déterminer les paramètres de filtrage nécessaires à la suppression de la fonction de perturbation et par ailleurs la prise en charge des paramètres de filtrage ainsi obtenus est déterminée sur le premier filtre adaptatif (3).

2. Circuit selon la revendication 1, caractérisé en ce qu'il est prévu un deuxième filtre passe-haut (7), auquel est amené le signal non perturbé V_{R(o)} et un comparateur (en 6), auquel sont amenées les sorties du deuxième filtre adaptatif numérique (5), et du deuxième filtre passe-haut (7), et qui opère la transmission au premier filtre adaptatif (3), quand le comparateur (en 6) détermine un meilleur réglage du deuxième filtre adaptatif numérique (5).

3. Circuit de conversion selon la revendication 1 ou 2, caractérisé en ce que les filtres adaptatifs (3, 5) sont des filtres adaptatifs en cascade.

4. Circuit selon la revendication 1 ou 2, caractérisé en ce que l'intervalle de temps pour la conversion du deuxième filtre adaptatif (5) sur l'adaptation est déterminé dans un appareil de régulation anti-blocage (ABS) par le sous-dépassement d'un seuil d'accélération de roue après une chute de pression.
